# EUROPÄISCHE PATENTANMELDUNG

(11) **EP 1 113 438 A2**
(43) Veröffentlichungstag der Anmeldung: **04.07.2001**
(21) Anmeldenummer: 00127620.3
(22) Anmeldetag: 16.12.2000
(51) Int. Cl.: G11B 23/04, G11B 23/03, G11B 31/00

(54) **Medium für einen Media-Player**

(30) Priorität: 30.12.1999 DE 19964062; 30.12.1999 DE 19964064
(71) Anmelder: AM3 AutoMotive MultiMedia AG, 90762 Fürth (DE)
(72) Erfinder: Herrn Dr. Ernst Hallas, 91301 Forchheim (DE)
(74) Vertreter: Pröll, Jürgen, Dipl.-Ing. (FH)

(57) **Zusammenfassung**

Die Erfindung betrifft ein Medium für einen Media-Player Das Medium weist eine Energieversorgungseinheit auf, welche den Antrieb des Media-Players adaptiert und in eine Spannung für das Medium umwandelt. Im weiteren ist auf dem Medium ein Mikroprozessor, eine Übertragungseinheit, sowie mindestens eine Aufnahmevorrichtung für Speichereinheiten mit digital gespeicherten Daten vorgesehen.

## Beschreibung

Die Erfindung betrifft ein Medium für einen Media-Player gemäß dem Oberbegriff des Anspruches 1 und 6.

Medien für Media-Player sind weithin bekannt. Hierzu zählen Musik-Kompakt-Kassetten, Compact-Disks und beispielsweise Flash-Speicher mit MP3-Dateien.

Im weiteren sind beispielsweise Autoradios mit abklappbarer Front in verschiedensten Ausführungen bekannt. Ein aus dem deutschen Gebrauchsmuster 90 07 501 U1 bekanntes Autoradio zeigt eine abklappbare Front, welche im abgeklappten Zustand zusätzliche Bedienungselemente oder die Einführöffnung für den Ton-Bildträger eines Media-Players, der beispielsweise ein Kassettenlaufwerk, ein CD-Laufwerk oder auch ein DVD-Laufwerk darstellen kann, freigibt. Damit können im abgeklappten Zustand diese zusätzlichen Bedienungselemente betätigt oder der Bild-Tonträger in den Media-Player eingeführt werden. Dagegen können im nicht abgeklappten Zustand die zusätzlichen Bedienungselemente nicht betätigt werden bzw. der Ton-Bildträger nicht in den Media-Player eingeführt werden, da eine Verdeckung durch die abklappbare Front gegeben ist. Derartige Geräte bedürfen aber zur Benutzung bzw. zur Installation spezifischer Geräte eigener Daten.

Aus dem deutschen Gebrauchsmuster 88 02 620 U1 ist ein Autoradio bekannt, in dessen Kassettenschachtöffnung ein Kunststoffteil eingeführt wird oder diesen entnommen werden kann. Das entnehmbare Kunststoffteil ragt dabei teilweise in den Kassettenschacht hinein, während ein anderer Teil aus dem Kassettenschacht herausragt.

Im weiteren ist aus dem deutschen Patent DE 198 09 154 ein Autoradio mit abklappbarer Front mit einem Media-Player, dessen Ton-Bildträger durch eine Öffnung im Gehäuse des Autoradios vollständig einführbar ist, wobei die Öffnung so angeordnet ist, daß sie bei abgeklappter Front zu Einführung des Ton-Bildträgers zugänglich ist, bekannt. Bei nicht abgeklappter Front ist der Zugriff verschlossen. Ein aus dem Autoradio abnehmbares Bauteil zur Aufnahme gerätespezifischer Daten, wie Garantiekarte, Code-Nummer, Gerätenummer oder ähnliches ist vorgesehen, wobei das entnehmbare Bauteil die Gestalt des Ton-Bildträgers aufweist. Im weiteren sind Adapterkassetten, zum Beispiel von CD-Playern, insbesondere CD-Walkman, bekannt, um Tonsignale in ein Kassettenautoradio einzuspielen. Hierbei wird die Spannung beispielsweise von Zigarettenanzündern aus dem Bordnetz des Kraftfahrzeugs bezogen. Die Signale, welche über Line-Out des Gerätes bereitgestellt werden, werden in das Adapterkassettenbauteil geleitet. Nachteilig hierbei ist, daß verschiedene Kabel aus der Adapterkassette, und folglich aus dem Gerät herausragen und störend bei der Bedienung sind.

Aus DE 41 35 220 C1 ist eine Smartkassette mit einer eingebauten Magnetschnittstelle, einem Analog-Digital-Wandler, einem Digital-Analog-Wandler, einem Prozessor, einem Speicherbaustein, einem Stromgenerator, einem Stromregulator und einer Batterie bekannt. Über eine digitale Schnittstelle wird von einem Ladegerät über dessen Schnittstelle digitalisierte Musik in den Prozessor geladen. Dort wird diese komprimiert und danach im Speicher gespeichert. Die digitalisierte Musik wird über den Speicher in den Prozessor geladen, dort entkomprimiert und über den Digital-Analog-Wandler, den Verstärker und die Magnetschnittstelle auf herkömmliche Kassettenabspielgeräte in der für digital aufgezeichnete Musikstücke übliche Qualität abgespielt.

Aus DE 39 034 54 A1 ist ein in eine EDV-Einrichtung einsteckbares Element mit einer Schnittstelle bekannt. Das Element ist mit einem Prozessor mit einem Speicher ausgerüstet. Die Schnittstelle ist derart ausgebildet, dass eine Datenübertragung zwischen dem Prozessor des Elements und der EDV-Einrichtung über die in der EDV-Einrichtung vorhandenen Schreib-Lese-Einrichtungen durchführbar ist.

Aus US 5,584,043 A ist ein einsteckbares Element in eine Diskettenstation einer EDV-Einrichtung mit einer Schnittstelle bekannt. Diese Schnittstelle ist derart ausgebildet, dass eine Datenübertragung zwischen der EDV-Einrichtung und dem Element über die in der EDV-Einrichtung ohnehin vorhandenen Schreibe-Lese-Einrichtung durchführbar ist. Um die Vielfalt der Anwendungs- und Einsatzmöglichkeiten des Elements zu vergrössern, ist das Element aus zwei zusammensteckbaren Komponenten zusammengesetzt. Eine Komponente stellt die äussere Form einer Diskette dar und dient als Rahmen für die Aufnahme der zweiten Komponente, welche sämtliche elektronischen Bauteile enthält.

Im weiteren sind MP3-Player bekannt. Hierbei wird eine Speicherkarte, beispielsweise eine Multi-Media-Karte, oder auch eine Flash-Karte in ein Abspielgerät eingeführt. Die digital vorliegenden Daten werden in Analog-Daten gewandelt und über eine akustische Einheit wiedergegeben.

Problematisch bei derartigen Playern ist jedoch, daß diese eigenständige Geräte sind. Ein Anschluß an ein bereits bestehendes Media-Player-System kann nur über Anschlußkabel erfolgen.

Aufgabe der Erfindung ist, es eine Einkopplung von Daten von neueren Speichermedien, insbesondere Multi-Media-Cards, in bestehende Media-Player zu ermöglichen, unter Vermeidung der Problematik der Verkabelung. Außerdem soll es für den Besitzer von älteren Geräten der Unterhaltungselektronik die Möglichkeit zu eröffnen Daten und digital gespeicherte Musikstücke, welche auf handelsüblichen Medien, insbesondere Multimedia-Karten, gespeichert sind, auch mit diesen Geräten nutzen zu können. Zugleich besteht die Aufgabe darin eine kostengünstige Ausgestaltungsvariante zu ermöglichen.

Diese Aufgabe wird erfindungsgemäß mit den Merkmalen des Anspruches 1 und 6 gelöst.

Vorteilhafte Weiterbildungen der Erfindung ergeben sich aus den anhängigen Ansprüchen sowie der weiteren Beschreibung.

Erfindungsgemäß weist ein Media-Player eine Einschuböffnung für ein entsprechendes Kassettenmedium auf. Bei diesem Kassettenmedium handelt es sich vorzugsweise um eine Musikbandkassette oder eine Compact-Disk oder eine DVD.

Das erfindungsgemäße Medium für den Media-Player hat die Form einer Musik-Kassette, einer Compact-Disk oder einer DVD und weist eine eigene Energieversorgungseinheit auf. Über diese Energieversorgungseinheit werden weitere auf dem Medium vorhandene elektronische Komponenten mit Energie versorgt. Die Energieversorgungseinheit ist als Generator mit einer Gleichrichtereinheit und einer Spannungsglättungseinheit ausgestattet.

Das Medium in Form einer Musik-Kassette, im weiteren als Kassettenmedium bezeichnet, wird in den Media-Player eingeschoben. Der Media-Player ist mit einer Antriebseinheit ausgestattet, welche das Kassettenmedium antreibt, d.h. bei herkömmlichen Musik-Kassetten wird vom Media-Player über dessen Antriebseinheit das Band der Musik-Kompakt-Kassette am Tonkopf des Media-Players vorbeigezogen. Die Erfindung macht von diesem Antrieb nutzen. Die Energieversorgungseinheit ist auf dem Kassettenmedium für den Media-Player derart angeordnet, daß der Vortrieb des Media-Players für das Kassettenmedium zur Energieversorgung genutzt wird.

Das weitere erfindungsgemäße Medium für den Media-Player hat die Form einer Scheibe und entspricht in den Abmessungen einer Compact-Disk bzw. einer DVD. Dieses Medium, im weiteren als Diskmedium bezeichnet, für den Media-Player weist ebenfalls eine eigene Energieversorgungseinheit auf. Über diese Energieversorgungseinheit werden weitere in bzw. auf dem Diskmedium vorhandene elektronische Komponenten mit Energie versorgt. Die Energieversorgungseinheit ist ebenfalls als Generator mit einer Gleichrichtereinheit und einer Spannungsglättungseinheit ausgestattet.

Das Diskmedium wird in den Media-Player eingeschoben. Der Media-Player ist mit einer Antriebseinheit ausgestattet, welche das Diskmedium antreibt, d.h. bei Compact-Disks bzw. DVDs wird vom Media-Player über dessen Antriebseinheit die Compact-Disk bzw. DVD in eine Drehbewegung versetzt und die Oberfläche von einem Laserstrahl abgetastet. Die Erfindung macht von diesem Antrieb nutzen. Die Energieversorgungseinheit ist auf dem Diskmedium für den Media-Player derart angeordnet, dass der Vortrieb des Media-Players für das Diskmedium zur Energieversorgung genutzt wird.

Die weitere Ausgestaltung der Erfindung wird anhand zweier konkreter Ausführungsbeispiele anhand eines Mediums in Form einer Musik-Kompakt-Kassette und eines Mediums in Form einer Compact-Disk dargestellt.

Es zeigt:
- FIG 1: eine schematische Darstellung des Kassettenmediums mit den wesentlichen Funktionseinheiten der Erfindung.
- FIG 2: einen Schnitt durch das Kassettenmedium,

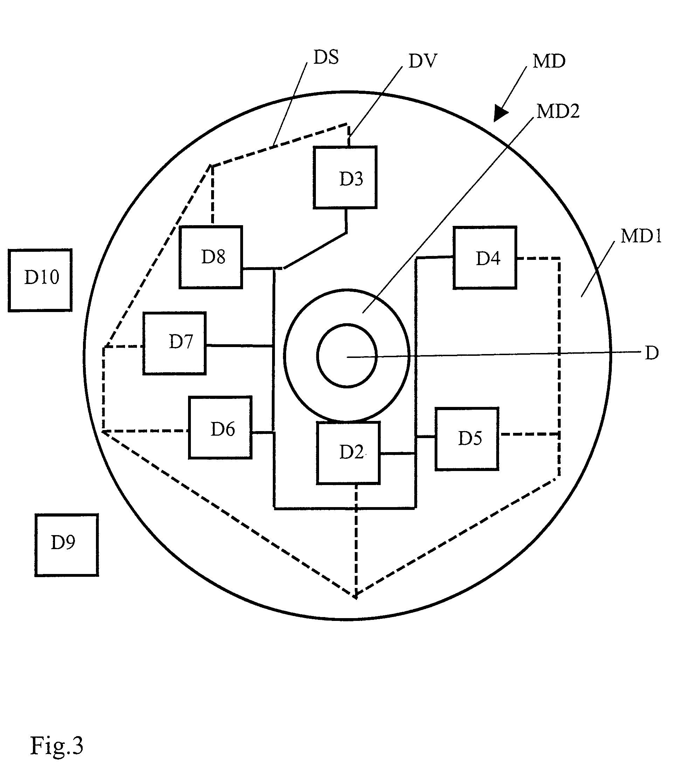

- FIG 3: eine schematische Darstellung des Diskmediums mit den wesentlichen Funktionseinheiten der Erfindung,
- FIG 4: eine schematische Ausgestaltung des Diskmediums in Form einer Schnittansicht durch das Diskmedium,
- FIG 5: eine weitere schematische Ausgestaltung des Diskmediums in Form einer Schnittansicht durch das Diskmedium und
- FIG 6: zwei Ausgestaltungsformen der Bügel, welche das Diskmedium im Media-Player arretieren.

### Medium als Kompaktkassette

Das Kassettenmedium MK hat die Form einer herkömlichen Musik-Kompakt-Kassette.
Das Kassettenmedium MK weist zwei Öffnungen 8, 9 auf. In diese Öffnungen 8, 9 greift im Media-Player dessen Vortrieb, welcher bei herkömmlichen Musik-Kompakt-Kassetten den Bandzug durchführt. Üblicherweise ist um die Öffnungen 8, 9 das Band der Musik-Kompakt-Kassette aufgespult. Im Media-Player ist eine Antriebseinheit vorhanden, welche über die Öffnungen 8, 9 das Band in der Musik-Kompakt-Kassette antreibt und vorantreibt.

Das Kassettenmedium MK weist eine Energieversorgungseinheit K2, verschiedene Aufnahmevorrichtungen K3, K4, K5 für Speichermedien, insbesondere Multi-Media-Cards, auf. Im weiteren ist ein Mikroprozessor K6, sowie eine Übertragungseinheit K7 vorgesehen.

Die Energieversorungseinheit K2 ist an den Antrieb des Media-Players über die Öffnung K9 und/oder K8 gekoppelt. Die Öffnung K8, K9 ist als Zahnrad ausgebildet. Durch das Drehen des Zahnrades wird ein Generator in der Energieversorgungseinheit K2 angetrieben. Dieser Generator erzeugt eine Wechselspannung. Diese Wechselspannung wird über eine Gleichrichtereinheit sowie eine Spannungsglättungseinheit geführt. Die Energieversorgungseinheit K2 stellt über die Versorgungsleitungen KV eine Versorgungsspannung für die elektrischen Bauteile K3, K4, K5, K6, K7 des Kassettenmediums MK bereit.

Über die Aufnahmevorrichtungen K3, K4, K5 für Speichermedien können verschiedene Speichermedien wie z.B. Multi-Media-Cards, Flash-Speicher, Speichersticks usw. eingeführt werden. Hierzu sind jeweils mechanische als auch elektrische Schnittstellen vorgesehen, um die entsprechenden Speicher bzw. Medien zu adaptieren. Im weiteren ist ein Mikroprozessor K6 vorgesehen. Dieser Mikroprozessor K6 weist einen Festwertspeicher KF auf. Sobald das Kassettenmedium MK in den Media-Player eingeschoben ist, treibt dieser über die Öffnung K9 und/oder K8 die Energieversorgungseinheit K2 an. Die Energieversorgungseinheit K2 stellt dann die Versorgungspannung über die Spannungsversorgungsleitungen KV für die elektrischen Komponenten K2, K3, K4, K5, K6, K7 bereit. Sobald die Spannung vorhanden ist, wird der Mikroprozessor K6 aktiviert und prüft über die Steuerleitungen KS, ob Medien bzw. Speichermedien in den Aufnahmevorrichtungen K3, K4, K5 eingefügt sind. Ist dies der Fall, so beginnt der Mikroprozessor K6 die Daten sequentiell, der Reihe nach aus diesen Speichermedien auszulesen.

Zum besseren Verständnis wird im weiteren angenommen, daß lediglich in der Aufnahmevorrichtung K3 eine Multi-Media-Card vorhanden ist. Der Mikroprozessor K6 geht nun wie folgt vor:

Über die Steuerleitungen KS spricht der Mikroprozessor K6 die Multi-Media-Card in der Aufnahmevorrichtung K3 an und liest die Daten sequentiell aus. Der Mikroprozessor K6 leitet die Daten an die Übertragungseinheit K7 weiter. Die Übertragungseinheit K7 weist einen Digital-Analog-Wandler auf, sowie einen Adapter an den Signalabnehmer für den Media-Player auf. Bei einem Media-Player für Musik-Kompakt-Kassetten handelt es sich üblicherweise um ein Bandabspielgerät mit einem magnetischen Tonkopf. Die Übertragungseinheit K7 adaptiert diesen Tonkopf und überträgt die vorliegenden Daten über die Adaption an den Tonkopf in den Media-Player.

Auf diese Art und Weise ist es überraschend einfach möglich, für bereits bestehende Media-Player eine Adaption für verschiedene Speicherkarten, wie etwa Multi-Media-Cards zu erreichen.

In einer weiteren Ausgestaltung der Erfindung ist vorgesehen, daß die Energieversorgungseinheit K2 über ein Getriebe an den Antrieb des Media-Players gekoppelt ist. Über das Getriebe ist es möglich die Versorgungsspannung insbesondere, die Leistung des Generators der Energieversorgungseinheit K2 zu erhöhen.

In einer weiteren Ausgestaltungform der Erfindung ist vorgesehen, daß die Energieversorgungseinheit K2 zwei Generatoren, und jeweils für jeden Generator eine Gleitrichtereinheit und eine Spannungsglättungseinheit vorgesehen ist. Um eine höhere Spannung und eine höhere Leistung erreichen zu können, werden beide Ausgangsspannungen in Reihenschaltung an die Spannungsversorgungsleitung KV angeschlossen.

In einer weiteren Ausgestaltungsform der Erfindung ist auf dem Kassettenmedium MK eine Empfangseinheit vorgesehen. Zu dieser Empfangseinheit existiert eine Sendeeinheit, welche als Bedieneinheit mit Bedientasten ausgestaltet ist. Über diese Bedieneinheit ist es möglich das Kassettenmedium zu steuern. Es sind verschiedene Bedienbefehle, wie etwa Auswahl des Speichermediums in den Aufnahmevorrichtung K3, K4, K5 auswählbar, es kann ein Titel übersprungen werden oder ein Titel wiederholt werden. Wird über die Bedieneinheit ein Bedienbefehl eingegeben, so wird dieser über die Sendeeinheit an die Empfangseinheit auf dem Kassettenmedium MK übertragen. Die Sendeeinheit leitet den empfangenen Befehl an den Mikroprozessor K6 weiter, der den Befehl ausführt.

In einer weiteren Ausgestalungsform der Erfindung ist die Übertragungseinheit K7 durch Sendeeinheiten ersetzt. Über die Steuerleitung KS spricht der Mikroprozessor K6 die Multi-Media-Card in der Aufnahmevorrichtung K3 an und liest die Daten sequentiell aus. Der Mikroprozessor K6 leitet die Daten an die Sendeeinheiten weiter. Vor der Weiterleitung der Daten an die Sendeeinheiten trennt der Mikroprozessor K6 die Audiodaten nach linkem und rechten Audiokanal und wandelt die digitalen Daten in analoge Signal. Die Sendeeinheiten senden per Funk die Audiosignale an zugehörige Empfangseinheiten. Die Empfangseinheiten sind an die Line-In Eingänge des Mediaplayers angeschlossen. Die Empfangseinheiten empfangen die von den Sendeeinheiten gesendeten Signale und übertragen diese über die Line-In Eingänge des Media-Players in den Media-Player. Es sind jeweils zwei Sendeeinheiten und zwei Empfangseinheiten vorgesehen, wobei jeweils ein Stereotonkanal von einer Sendeeinheit an die zugehörige Empfangseinheit sendet.
Im weiteren werden die Empfangseinheiten über eine Spannungsversorgungsleitung, welche an der Spannungsversorgung des Media-Players angeschlossen ist, mit Energie versorgt.

In einer weiteren vorteilhaften Ausgestaltung der Erfindung ist das Sendeeinheiten und die Empfangseinheiten mit Sendern und Empfängern ausgestattet, welche nach dem Blue-Tooth-Konzept arbeiten. Beim Blue-Tooth-Konzept handelt es sich um eine Funkschnittstelle, welche für kurze Übertragungsstrecken geeignet ist und insbesondere geeignet ist Audiodaten zu übertragen, da die Bandbreite der Sender beschränkt ist.

### Medium als Diskmedium

Das Diskmedium hat die Form und die Abmessung einer herkömmlichen Musik-Compact-Disk.
Das Diskmedium MD besteht aus zwei Scheiben MD1 und MD2, welche beweglich zueinander gelagert sind. Die Scheibe MD2 ist in der Scheibe MD1 eingesetzt und drehbar zur Scheibe MD1.

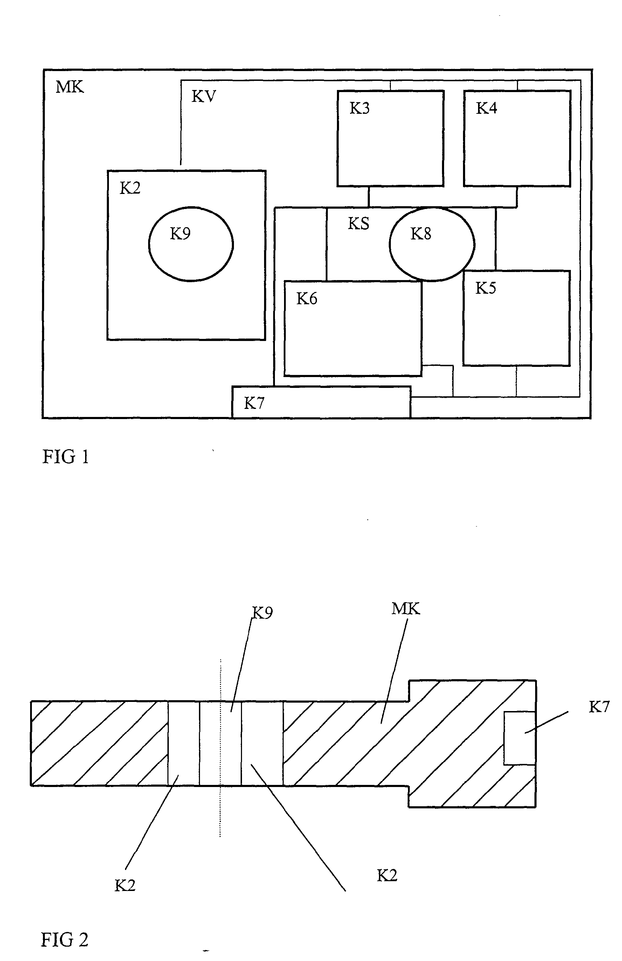

Das Diskmedium MD gemäß FIG 1 weist eine Öffnung D auf. In diese Öffnungen D greift im Media-Player dessen Vortrieb, welcher bei herkömmlichen Compact-Disks die Drehung der Compact-Disk bewirkt. Im Media-Player ist eine Antriebseinheit vorhanden, welche über die Öffnungen D die Scheibe MD2 des Diskmediums MD antreibt und in eine Drehbewegung versetzt.
An dem Diskmedium MD, genauer an der Scheibe MD1 ist ein Bügel angeordnet, der bei in den Media-Player eingeführtem Diskmedium MD die Scheibe MD1 des Diskmediums MD im Media-Player fixiert. Wird die Scheibe MD2 des Diskmediums MD vom Media-Player gedreht, ist auf diese Weise gewährleistet, daß die Scheibe MD1 des Diskmediums MD fest ist und sich die Scheibe MD2 des Diskmediums MD dreht.

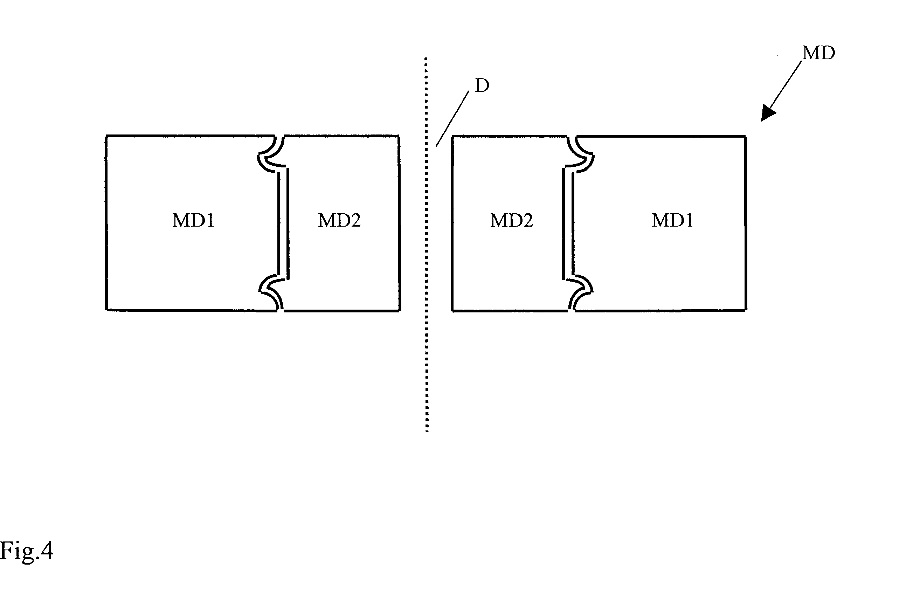

In FIG 4 ist eine Ausgestaltungsform des Diskmediums MD dargestellt, in welchem die Scheibe MD2 die Öffnung D des Diskmediums MD komplett umschließt. Die Scheibe MD1 umschließt die Scheibe MD2. Die Scheibe MD2 ist in der Scheibe MD1 drehbar um die Öffnung D gelagert.

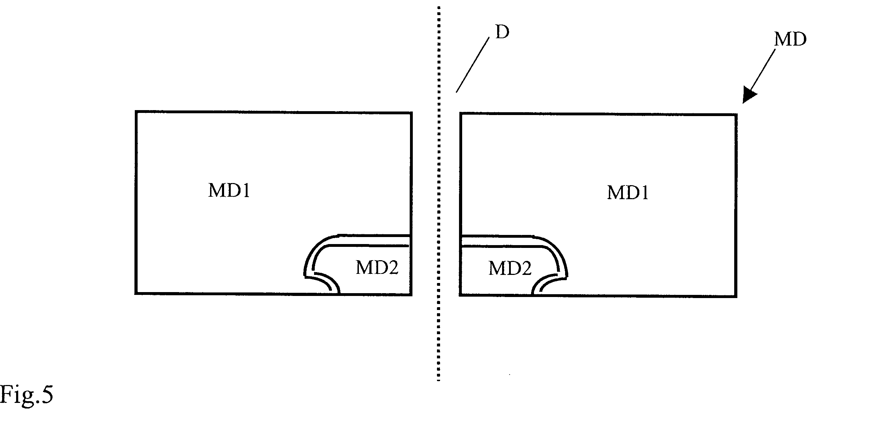

In FIG 5 ist eine weitere Ausgestaltungsform der Erfindung dargestellt bei welcher die Scheibe MD2 die Öffnung D des Diskmediums MD nicht komplett umschließt, sondern in der Scheibe MD1 um die Öffnung D drehbar eingebettet ist.

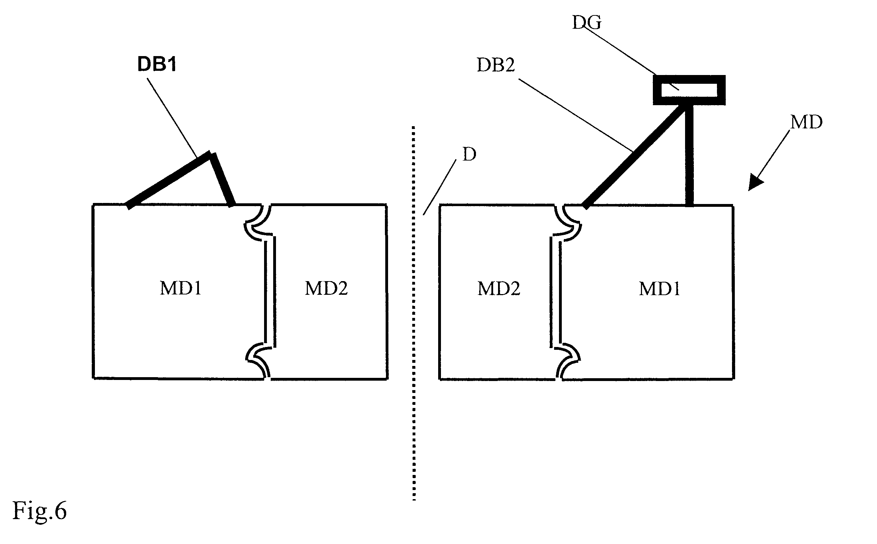

In FIG 6 ist schematisch das Diskmedium MD mit aufgestellten Bügeln zur Arretierung im Media-Player dargestellt.

Das Diskmedium MD weist eine Energieversorgungseinheit D2, verschiedene Aufnahmevorrichtungen D3, D4, D5 für Speichermedien, insbesondere Multi-Media-Cards, Speicherkarten, Memorysticks usw. auf. Im weiteren sind ein Mikroprozessor D6, sowie Sendeeinheiten D7, D8 vorgesehen.

Wenn die Scheibe MD2 gedreht wird, so tritt durch die Massenträgheit und die Winkelbeschleunigung zunächst sofort aufgrund der Impulserhaltung eine Differenzdrehzahl zwischen MD1 und MD2 auf. Durch den Widerstand der Energieversorgungseinheit D2, welche auf der Scheibe MD1 angeordnet ist und die Drehung der Scheibe MD2 wird diese zur Energieerzeugung verwendet. Es entsteht ein Mitnahmeeffekt, der Anfangsimpuls der Drehung wird aber bereits für die Arretierung von MD1 im Media-Player genutzt. Dies kann auf folgende Arten erfolgen:
a) Durch eine Fliehkraftbewegung des mechanischen Bügels, welcher in einer vorteilhaften Ausgestaltung der Erfindung in Form von zwei Bügeln ausgestaltet ist, welche symmetrisch zur Rotationsachse der Scheibe MD2 angeordnet sind. Der Bügel ist auf der Scheibe MD1 angeordnet, wobei seine Fixierungen auf der Scheibe MD1 punktsymmetrisch zum Drehpunkt der Scheibe MD2 angeordnet sind. Der Bügel verklemmt sich im Media-Player und arretiert die Scheibe MD1. Die Scheibe MD2 kann sich drehen.
b) Durch eine elektronische Unterstützung. Hierbei wird die Drehbewegung der Scheibe MD1 zur Scheibe MD2 durch geeignete Mittel zur Bewegung und Arretierung des Bügels verwendet werden. Beispielsweise über ein Getriebe, welches die Drehbewegung der Scheibe MD2 zur Scheibe MD1 in eine Bewegung des Bügels umsetzt und sich dieser aufrichtet um im Media-Player arretiert.
c) Durch eine Pufferbatterie welche eine elektromechanische Einheit mit Energie versorgt, welche den Bügel von der Scheibe MD1 aufstellen läßt, damit sich dieser im Media-Player arretiert. Die Pufferbatterie hat nur eine geringe Energiekapazität, die jedoch ausreichen ist, um die elektromechanische Einheit zu betätigen. Die Pufferbatterie wird über die Energieversorgungseinheit D2 wieder aufgeladen.

Der Bügel ist durch geeignete Haltemittel auf der Scheibe MD1 und einer entsprechenden Materialauswahl des Bügels realisiert, so dass das Laufwerk des Media-Players nicht beeinträchtigt wird. Es hat sich als vorteilhaft erwiesen, den Bügel aus Weichgumme herzustellen.

Der Bügel ist in einer Ausgestaltungsform als Bügel DB1 gemäß FIG 4 oder als Bügel DB2 mit einem Gummipuffer DG, gemäß FIG 4 ausgestaltet.

Die Energieversorungseinheit D2 ist mit der Scheibe MD2 des Diskmediums MD gekoppelt und auf der Scheibe MD1 angeordnet. Über ein Rad wird die Drehbewegung des Scheibe MD2 auf die Generatoreinheit der Energieversorungseinheit D2 übertragen. Die Generatoreinheit der Energieversorgungseinheit D2 wandelt die Drehbewegung der Scheibe MD2 über das gekoppelte Rad in eine Wechselspannung um. Diese Wechselspannung wird über eine Gleichrichtereinheit sowie eine Spannungsglättungseinheit geführt. Die Energieversorgungseinheit D2 stellt über die Versorgungsleitungen DV eine Versorgungsspannung für die elektrischen Bauteile D3, D4, D5, D6, D7, D8 des Diskmediums MD bereit. Über die Aufnahmevorrichtungen D3, D4, D5 für Speichermedien können verschiedene Speichermedien wie z.B. Multi-Media-Cards, Flash-Speicher in der Karte eingeführt werden. Hierzu sind mechanische als auch elektrische Schnittstellen jeweils vorgesehen, um die entsprechenden Speicher bzw. Medien zu adaptieren. Im weiteren ist ein Mikroprozessor D6 vorgesehen. Dieser Mikroprozessor D6 weist einen Festwertspeicher DF auf.

Sobald das Diskmedium MD in den Media-Player eingeschoben ist, treibt dieser über die Scheibe MD2 die Energieversorgungseinheit D2 an. Die Energieversorgungseinheit D2 stellt dann die Versorgungspannung über die Spannungsleitungen DV für die elektrischen Komponenten D2, D3, D4, D5, D6, D7, D8 bereit. Sobald die Spannung vorhanden ist, wird der Mikroprozessor D6 aktiviert und prüft über die Steuerleitungen DS, ob Medien in den Aufnahmevorrichtungen D3, D4, D5 vorhanden sind. Ist dies der Fall, so beginnt der Mikroprozessor D6 die Daten sequentiell, der Reihe nach auszulesen.

Zum besseren Verständnis wird im weiteren angenommen, daß lediglich in der Aufnahmevorrichtung D3 eine Multi-Media-Card vorhanden ist. Der Mikroprozessor D6 geht nun wie folgt vor:

Über die Steuerleitungen DS spricht der Mikroprozessor D6 die Multi-Media-Card in der Aufnahmevorrichtung D3 an und liest die Daten sequentiell aus. Der Mikroprozessor D6 leitet die Daten an die Sendeeinheiten D7, D8 weiter. Vor der Weiterleitung der Daten an die Sendeeinheiten D7, D8 trennt der Mikroprozessor D6 die Audiodaten nach linkem und rechten Audiokanal und wandelt die digitalen Daten in analoge Signal. Die Sendeeinheiten D7, D8 senden per Funk Audiosignale an Empfangseinheiten D9, D10. Die Empfangseinheiten D9, D10 sind an die Line-In Eingänge des Mediaplayers angeschlossen. Die Empfamgseinheiten D9, D10 empfangen die von den Sendeeinheiten D7, D8 gesendeten Signale und übertragen diese über die Line-In Eingänge des Media-Players an den Media-Player.
Im weiteren werden die Empfangseinheiten über eine Spannungsversorgungsleitung DV, welche an der Spannungsversorgung des Media-Players angeschlossen ist, mit Energie versorgt.

In einer weiteren Ausgestaltung der Erfindung ist vorgesehen, daß die Energieversorgungseinheit D2 über ein Getriebe an die Scheibe MD2 des Diskmediums MD gekoppelt ist. Über das Getriebe ist es möglich die Versorgungsspannung, insbesondere die Leistung des Generators der Energieversorgungseinheit D2, zu erhöhen.

### Bezugszeichenliste

### Kassettenmedium

- MK: Kassettenmedium
- K2: Energieversorgungseinheit
- K3, K4, K5: Aufnahmevorrichtung
- K6: Mikroprozessoreinheit
- K7: Übertragungseinheit
- K8, K9: Öffnung
- KS: Steuerleitung
- KV: Spannungsversorgungsleitung
- KF: Festspeicher

### Diskmedium

- MD: Diskmedium
- MD1, MD2: Scheibe
- D2: Energieversorgungseinheit
- D3, D4, D5: Aufnahmevorrichtung
- D6: Mikroprozessoreinheit
- D7, D8: Sendereinheit
- D9, D10: Empfängereinheit
- DV: Versorgungsleitung
- DS: Steuer-/Datenbus
- DB1, DB2: Bügel
- DG: Gummipuffer
- DF: Festspeicher
- D: Öffnung

## Patentansprüche

1. Medium (MK) für einen Mediaplayer mit einer Energieversorgungseinheit (K2), welche den Antrieb des Mediaplayers adaptiert und in Energie für die Einheiten (K2, K6, K7) des Medium (MK) umwandelt, einer Mikroprozessoreinheit (K6), einer Übertragungseinheit (K7), sowie mindestens einer Aufnahmevorrichtung (K3, K4, K5) für Speichereinheiten mit digital gespeicherten Daten,
**dadurch gekennzeichnet, dass**
die Energieversorgungseinheit (K2), eine Generatoreinheit, eine Gleichrichtereinheit sowie eine Spannungsglättungseinheit aufweist, die Generatoreinheit der Energieversorgungseinheit (K2) mit dem Antrieb des Mediaplayers gekoppelt ist und eine Getriebeeinheit zwischen dem Antrieb des Mediaplayers und der Generatoreinheit vorgesehen ist, mittels welcher die Drehgeschwindigkeit der Generatoreinheit der Energieversorgungseinheit (K2) erhöhbar ist.

2. Medium (MK) nach Anspruch 1,
**dadurch gekennzeichnet, dass,**
das Medium (MK) die Form einer Musikkompaktkassette hat und der Mediaplayer ein Musik-Kompakt-Kassetten-Abspielgerät oder ein Audioradio mit Kompaktkassetten-Abspieleinheit ist.

3. Medium (MK) nach Anspruch 1 oder 2,
**dadurch gekennzeichnet, dass**
die Generatoreinheit bzw. die Getriebeeinheit über ein Zahnrad über eine Öffnung (K9) im Medium (MK) mit dem Antrieb des Mediaplayers gekoppelt ist.

4. Medium (MK) nach einem oder mehreren der Ansprüche 1 bis 3,
**dadurch gekennzeichnet, dass**
die Mikroprozessoreinheit (K6) die Getriebeeinheit zuschaltet, wenn die aktuell abgegebene Leistung der Energieversorgungseinheit (K2) nicht ausreicht um sämtliche Einheiten (K2, K6, K7) und Vorrichtungen (K3, K4, K5) des Mediums (MK) mit ausreichend Energie zu versorgen und die Aufnahmevorrichtungen (K3, K4, K5) mindestens eine mechanische und mindestens eine elektrische Schnittstelle aufweisen.

5. Medium (MK) nach einem oder mehreren der Ansprüche 1 bis 4,
**dadurch gekennzeichnet, dass**
die Übertragungseinheit (K7) den Tonkopf des Mediaplayers adaptiert.

6. Medium (MD) für einen Mediaplayer mit einer Energieversorgungseinheit (D2), welche aus dem Antrieb des Mediaplayers Energie für die Einheiten (D2, D3, D4, D5, D6, D7, D8) des Medium (MD) gewinnt, einer Mikroprozessoreinheit (D6), sowie mindestens einer Aufnahmevorrichtung (D3, D4, D5) für Speichereinheiten mit digital gespeicherten Daten,
**dadurch gekennzeichnet, dass**
das Medium (MD) eine Energieversorgungseinheit (D2) aufweist, welche die Bewegung des Mediums (MD) im Mediaplayer in eine Energie zur Versorgung der Einheiten (D2 bis D8) für das Medium (MD) umwandelt, und, mindestens eine Sendeeinheit (D7, D8) auf und/oder im Medium (MD) vorgesehen ist.

7. Medium (MD) nach Anspruch 6,
**dadurch gekennzeichnet, dass**
das Medium (MD) die Form einer Scheibe hat und die Abmessungen einer Compact-Disk bzw. einer DVD aufweist und das Diskmedium (MD) aus einer ersten Scheibe (MD1) und einer zweiten Scheibe (MD2) besteht und die Scheibe (MD2) in der Scheibe (MD1) drehbar gelagert ist.

8. Medium (MD) nach Anspruch 6,
**dadurch gekennzeichnet, dass**
die Energieversorgungseinheit (D2) eine Generatoreinheit, eine Gleichrichtereinheit sowie einen Spannungsglättungseinheit aufweist.

9. Medium (MD) nach einem oder mehreren der Ansprüche 6 bis 8,
**dadurch gekennzeichnet, dass**
der Media-Player ein Compact-Disk-Player oder eine Rundfunkgerät mit einem Compact-Disk-Player ist oder der Media-Player ein Autoradio mit Compact-Disk-Abspieleinheit ist.

10. Medium (MD) nach einem oder mehreren der Ansprüche 6 bis 9,
**dadurch gekennzeichnet, dass**
die Sendeeinheiten (D7, D8) die Audiodaten an Empfangseinheiten (D9, D10) per Funk übertragen und die Empfangseinheiten (D9, D10) die empfangenen Daten an die Line-In-Eingänge des Media-Players, an welche sie angeschlossen sind, einspeisen.

11. Medium (MD) nach einem oder mehreren der Ansprüche 6 bis 10,
**dadurch gekennzeichnet, dass**
die Aufnahmevorrichtungen (D3,D4, D5) einen Bügel aufweisen, durch welchen eine eingeschobene Speichereinheit auf dem Medium (MD) mechanisch form-und kraftschlüssig fixiert ist und der Bügel aus zwei bogenförmigen Streben aufgebaut ist und diese Streben auf der ersten Scheibe (MD1) fixiert und die Fixierungspunkte der Streben punktsymmetrisch zur Mitte des Diskmediums angeordnet sind.

12. Medium (MD) nach Anspruch 11,
**dadurch gekennzeichnet, dass**
der Bügel die Fliekraftbewegung beim Start der Bewegung der zweiten Scheibe (MD2) zur ersten Scheibe (MD1) ausnutzt um das Medium (MD) im Media-Player zu arretieren und der Bügel aus Weichgummi hergestellt ist.

13. Medium (MD) nach einem oder mehreren der Ansprüche 6 bis 12,
**dadurch gekennzeichnet, daß**
eine Getriebeeinheit vorgesehen ist, mittels welcher die Drehgeschwindigkeit des Generators der Energieversorgungseinheit (D2) erhöht werden kann. Und der Mikroprozessor (D6) die Getriebeeinheit zuschaltet, wenn die Leistung der Energieversorgungseinheit (D2) nicht ausreicht um sämtliche Komponenten der Diskmediums mit ausreichend Energie zu versorgen.

14. Medium (MK, MD) nach einem oder mehreren der Ansprüche 1 bis 5 oder 6 bis 13,
**dadurch gekennzeichnet, dass**
das Medium (MK, MD) aus Kunststoff oder Edelstahl besteht.

15. Medium (MK) nach einem oder mehreren der Ansprüche 1 bis 5 oder 6 bis 13,
**dadurch gekennzeichnet, dass**
die Aufnahmevorrichtungen (K3, K4, K5, D3, D4, D5) einen Bügel aufweisen; durch welchen eine eingeschobene Speichereinheit auf dem Medium (MK, MD) mechanisch form- und kraftschlüssig fixiert ist.

16. Medium (MK, MD) nach einem oder mehreren der Ansprüche 1 bis 5 oder 6 bis 13 oder 14 oder 15,
**dadurch gekennzeichnet, dass**
die Mikroprozessoreinheit (K6, D6) über die Steuerleitungen (KS, DS) die Aufnahmevorrichtungen (K3, K4, K5, D3, D4, D5) und die Übertragungseinheit (K7, D7, D8) steuert und dass die Mikroprozessoreinheit (K6, D6) einen Festwertspeicher (KS, DS) aufweist.

17. Medium (MK, MD) nach einem oder mehreren der Ansprüche 1 bis 5 oder 6 bis 13 oder 14 bis 16,
**dadurch gekennzeichnet, dass**
das Medium (MK, MD) eine Empfangseinheit aufweist und eine Sendeeinheit mit Bedientasten vorgesehen ist, mittels welcher Bedienbefehle über die Sendeeinheit an die Empfangseinheit auf dem Medium (MK, MD) übertragbar sind und diese Befehle von der Mikroprozessoreinheit (K6, D6) ausführbar sind.
